# EUROPEAN PATENT APPLICATION

(11) **EP 1 640 317 A2**
(43) Date of publication of application: **29.03.2006**
(21) Application number: 05255694.1
(22) Date of filing: 14.09.2005
(51) Int. Cl.: B81B 3/00, G02B 26/08

(54) **Methods of fabricating interferometric modulators by selectively removing a material**

(30) Priority: 27.09.2004 US 613401 P; 25.03.2005 US 90552; 25.03.2005 US 90778
(71) Applicant: IDC, LLC, San Francisco, CA 94107 (US)
(72) Inventor: Cummings, William J., Millbrae California 94030 (US); Kothari, Manish, Cupertino California 95014 (US); Tung, Ming-Hau, San Francisco California 94122 (US)
(74) Representative: Dunlop, Hugh Christopher

(57) **Abstract**

Methods for making MEMS devices such as interferometric modulators involve selectively removing a sacrificial portion (405) of a material to form an internal cavity (510), leaving behind a remaining portion of the material to form a post structure. The material may be blanket deposited and selectively altered to define sacrificial portions that are selectively removable relative to the remaining portions. Alternatively, a material layer can be laterally recessed away from openings in a covering layer. These methods may be used to make unreleased and released interferometric modulators.

## Description

### Background

### Field of the Invention

The field of the invention relates to microelectromechanical systems (MEMS).

### Description of the Related Technology

Microelectromechanical systems (MEMS) include micro mechanical elements, actuators, and electronics. Micromechanical elements may be created using deposition, etching, and or other micromachining processes that etch away parts of substrates and/or deposited material layers or that add layers to form electrical and electromechanical devices. One type of MEMS device is called an interferometric modulator. An interferometric modulator may comprise a pair of conductive plates, one or both of which may be transparent and/or reflective in whole or part and capable of relative motion upon application of an appropriate electrical signal. One plate may comprise a stationary layer deposited on a substrate, the other plate may comprise a metallic membrane separated from the stationary layer by a gap. Such devices have a wide range of applications, and it would be beneficial in the art to utilize and/or modify the characteristics of these types of devices so that their features can be exploited in improving existing products and creating new products that have not yet been developed.

### Summary

The system, method, and devices of the invention each have several aspects, no single one of which is solely responsible for its desirable attributes. Without limiting the scope of this invention, its more prominent features will now be discussed briefly. After considering this discussion, and particularly after reading the section entitled "Detailed Description of Preferred Embodiments" one will understand how the features of this invention provide advantages over other display devices.

One aspect provides a method for making a MEMS substrate (such as an interferometric modulator) that includes depositing a material over a first mirror layer; forming a second mirror layer over the material; and selectively removing a sacrificial portion of the material to thereby form a cavity and a support structure of the interferometric modulator. The support structure includes a remaining portion of the material. The second electrode layer includes a moveable layer supported by the support structure.

Another aspect provides an unreleased MEMS substrate that includes a material, the MEMS substrate being configured so that a sacrificial portion of the material is removable to form a cavity and so that a remaining portion of the material forms a post structure of an interferometric modulator upon removal of the sacrificial portion.

Another aspect provides a method of making an interferometric modulator. The interferometric modulator includes at least a first mirror, a second mirror separated from the first mirror by a cavity, and a post structure positioned at a side of the cavity and configured to support the second mirror spaced from the first mirror. The method for making this interferometric modulator includes providing a substrate, the substrate having a first area configured to underlie the first mirror and a second area configured to underlie the post structure, then depositing a first mirror layer over at least the first area. The method further includes depositing a material over the first area and the second area and selectively altering the material over the first area, the material over the second area, or both. The method further includes depositing a second mirror layer over at least the first area. The material over the first area is selected to be removable so that, upon removal of a sacrificial portion, a cavity and a post structure of the interferometric modulator are formed, wherein the post structure includes the material over the second area that remains after removal of the sacrificial portion.

Another aspect provides a method for making a MEMS device (such as an interferometric modulator) that includes depositing a material over a first mirror layer and depositing a second layer over the material. The second layer includes an opening formed through the second layer and configured to expose the material. The method further includes flowing an etchant through the opening and etching the material to remove a sacrificial portion of the material to thereby form a cavity and a support structure of the MEMS device, the support structure comprising a remaining portion of the material. The etching is non-selective between the sacrificial portion and the remaining portion of the material.

Another aspect provides an unreleased MEMS substrate that includes an underlying material and an overlying layer. The overlying layer is configured so that a sacrificial portion of the material is removable to form a cavity. The overlying layer is also configured so that a remaining portion of the material forms a post structure of an interferometric modulator upon removal of the sacrificial portion. The remaining portion and the sacrificial portion have substantially uniform properties.

Another aspect provides a method for making an interferometric modulator. The interferometric modulator includes at least a first mirror, a second mirror separated from the first mirror by a cavity, and a support structure positioned at a side of the cavity and configured to support the second mirror spaced from the first mirror. The method for making the interferometric modulator includes providing a substrate that has a first area configured to underlie the first mirror and a second area configured to underlie the support structure, and depositing a first mirror layer over at least the first area. The method further includes depositing a material over the first area and over the second area, and depositing a second mirror layer over at least the material over the first area. The method further includes forming a plurality of openings configured to facilitate flow of an etchant to the material over the first area. The material over the first area is removable by the etchant to thereby form the cavity and the post structure, where the post structure comprises the material over the second area. The sacrificial portion and the remaining portion are made of a material having substantially uniform properties.

Another embodiment provides an interferometric modulator made by a method described above. Another embodiment provides a system that includes such an interferometric modulator.

Another embodiment provides a MEMS device that includes means for selectively removing a sacrificial portion of a material relative to a remaining portion of the material; and means for supporting at least a portion of an interferometric modulator, the supporting means being formed upon removal of the sacrificial portion, the remaining portion and the sacrificial portion being made of a material having substantially uniform properties.

Another aspect provides an interferometric modulator that includes a post structure that has a re-entrant profile.

These and other embodiments are described in greater detail below.

### Brief Description of the Drawings

Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and column voltages that may be used to drive an interferometric modulator display.
Figures 5A and 5B illustrate one exemplary timing diagram for row and column signals that may be used to write a frame of display data to the 3x3 interferometric modulator display of Figure 2.
Figure 6A is a cross section of the device of Figure 1.
Figure 6B is a cross section of an alternative embodiment of an interferometric modulator.
Figure 6C is a cross section of another alternative embodiment of an interferometric modulator.
Figures 7-9 show cross sectional views that schematically illustrate aspects of a process flow for the fabrication of an interferometric modulator.
Figures 10-11 show cross sectional views of an embodiment that schematically illustrate aspects of a process flow for the fabrication of an interferometric modulator.
Figure 12 show cross sectional views of an embodiment that schematically illustrate aspects of a process flow for the fabrication of an interferometric modulator.
Figures 13-15 show cross sectional views of an embodiment that schematically illustrate aspects of a process flow for the fabrication of an interferometric modulator.
Figure 16 shows a top view photomicrograph of an embodiment depicting radial etching by a XeF₂ etchant flowing through a via of an interferometric modulator substrate.
Figures 17A - 17E show top view photomicrographs of an embodiment depicting the progressive etching of a interferometric modulator substrate by a XeF₂ etchant flowing through an array of vias.
Figures 18A - 18C show top view photomicrographs of an embodiment depicting the progressive etching of an interferometric modulator substrate by a XeF₂ etchant flowing through an array of horizontal and vertical vias.
Figure 19 shows cross sectional views of an embodiment that schematically illustrate aspects of a process flow for the fabrication of an interferometric modulator in which the upper mirror layer is suspended from a deformable or mechanical layer.
Figures 20A-20B show cross sectional views of an embodiment that schematically illustrate aspects of a process flow for the fabrication of an interferometric modulator in which the upper mirror layer is suspended from a deformable or mechanical layer.
Figures 21A-21B are system block diagrams, illustrating an embodiment of a visual display device comprising a plurality of interferometric modulators.

### Detailed Description of Preferred Embodiments

Preferred embodiments are directed to methods for making interferometric modulators in which the internal cavities and posts are both formed from a blanket layer by selectively removing a material, leaving behind the remaining material to form post structures. These methods may be used to make unreleased and released interferometric modulators. For example, an unreleased interferometric modulator substrate may be formed by depositing a first mirror layer, depositing a photosensitive polymer over the first mirror layer and over an adjacent area that will underlie a post structure in the resulting interferometric modulator, and then depositing a second mirror layer over the photosensitive polymer. The photosensitive polymer is irradiated to render a sacrificial portion of the photosensitive polymer that is between the first mirror layer and the second mirror layer selectively removable, thereby forming a cavity. The portion of the photosensitive polymer that is over the area that is adjacent to the first mirror layer remains behind to form a post structure after removal of the sacrificial portion. In another embodiment, the material between the mirror layers need not be a photosensitive polymer. For example, the material may be a blanket molybdenum layer and the overlying second mirror layer may be provided with vias that are positioned to allow a etchant (such as XeF₂) to selectively etch the molybdenum relative to the mirror layers. The molybdenum is thus recessed laterally under the second mirror layer, but only a sacrificial portion of the molybdenum is removed, leaving a remaining part of the molybdenum behind to form posts.

An embodiment provides a method for making an interferometric modulator comprising depositing a photosensitive polymer onto a substrate and selectively irradiating the photosensitive polymer to form a sacrificial layer and a post structure. For example, the photosensitive polymer may be selectively crosslinked by irradiation to form a post structure in the selectively irradiated areas and a sacrificial layer in the non-irradiated areas. The non-irradiated sacrificial portions are readily susceptible to removal by dissolution, e.g., by washing with commercially available resist stripping solutions that do not remove the irradiated portions. As another example, the photosensitive polymer may be selectively degraded by irradiation to form a sacrificial layer in the selectively irradiated area and a post structure in non-irradiated areas. In another embodiment, the method is continued by selectively etching the sacrificial layer (e.g., using a solvent that preferentially dissolves the sacrificial layer, leaving the post structure).

The following detailed description is directed to certain specific embodiments of the invention. However, the invention can be embodied in a multitude of different ways. In this description, reference is made to the drawings wherein like parts are designated with like numerals throughout.

As will be apparent from the following description, the structure described herein may be implemented in any device that is configured to display an image, whether in motion (e.g., video) or stationary (e.g., still image), and whether textual or pictorial. More particularly, it is contemplated that the structures and methods may be implemented in or associated with a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures, packaging, and aesthetic structures (e.g., display of images on a piece of jewelry). MEMS devices of similar structure to those described herein can also be used in non-display applications such as in electronic switching devices.

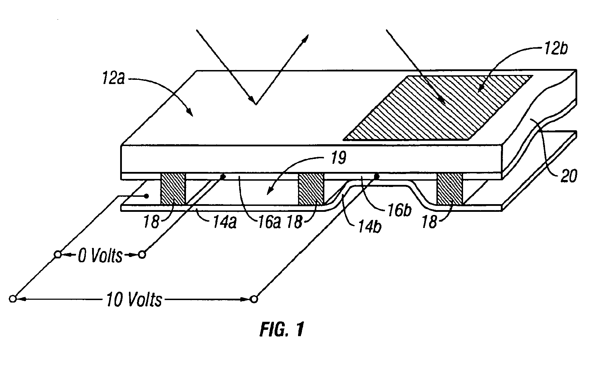

One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off'' or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure I is an isometric view depicting two adjacent pixels in a series of pixels of a visual display, wherein each pixel comprises a MEMS interferometric modulator. In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the released or relaxed state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure 1 includes two adjacent interferometric modulators **12a** and **12b.** In the interferometric modulator **12a** on the left, a movable and highly reflective layer **14a** is illustrated in a relaxed position at a predetermined distance from a fixed partially reflective layer **16a.** In the interferometric modulator **12b** on the right, the movable highly reflective layer **14b** is illustrated in an actuated position adjacent to the fixed partially reflective layer **16b.**

The fixed layers **16a, 16b** are electrically conductive, partially transparent and partially reflective, and may be fabricated, for example, by depositing one or more layers each of chromium and indium-tin-oxide onto a transparent substrate **20.** The layers are patterned into parallel strips, and may form row electrodes in a display device as described further below. The movable layers **14a, 14b** may be formed as a series of parallel strips of a deposited metal layer or layers (orthogonal to the row electrodes **16a, 16b)** deposited on top of posts **18** and an intervening sacrificial material deposited between the posts 18. When the sacrificial material is etched away, the deformable metal layers are separated from the fixed metal layers by a defined gap **19.** A highly conductive and reflective material such as aluminum may be used for the deformable layers, and these strips may form column electrodes in a display device.

With no applied voltage, the cavity **19** remains between the layers **14a, 16a** and the deformable layer is in a mechanically relaxed state as illustrated by the **pixel 12a** in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel **12b** on the right in Figure 1. The behavior is the same regardless of the polarity of the applied potential difference. In this way, row/column actuation that can control the reflective vs. non-reflective pixel states is analogous in many ways to that used in conventional LCD and other display technologies.

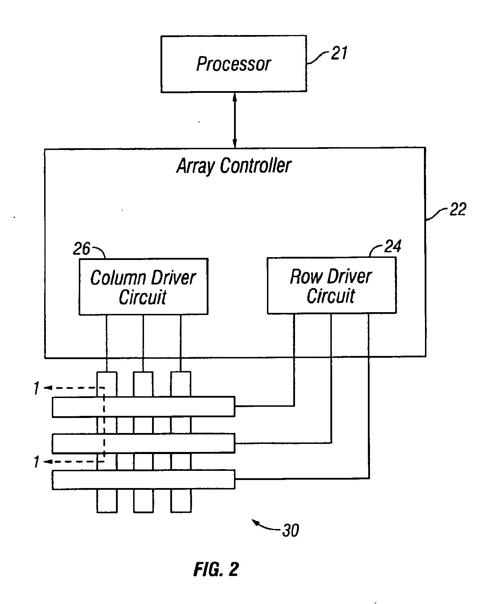

Figures 2 through 5 illustrate one exemplary process and system for using an array of interferometric modulators in a display application. Figure 2 is a system block diagram illustrating one embodiment of an electronic device that may incorporate aspects of the invention. In the exemplary embodiment, the electronic device includes a processor 21 which may be any general purpose single- or multi-chip microprocessor such as an ARM, PENTIUM® , PENTIUMII® , PENTIUMIII® , PENTIUMIV® , PENTIUM® PRO, an 8051, a MIPS® , a POWER PC® , an ALPHA® , or any special purpose microprocessor such as a digital signal processor, microcontroller, or a programmable gate array. As is conventional in the art, the processor **21** may be configured to execute one or more software modules. In addition to executing an operating system, the processor may be configured to execute one or more software applications, including a web browser, a telephone application, an email program, or any other software application.

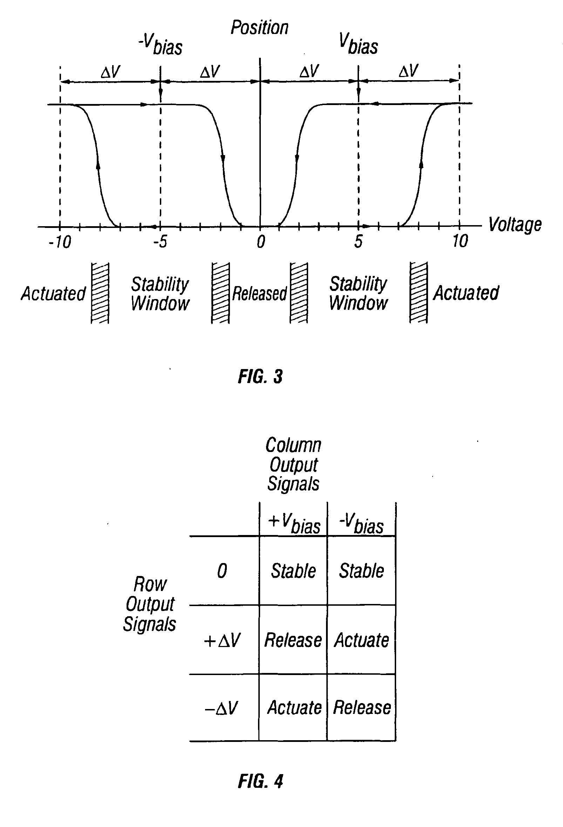

In one embodiment, the processor **21** is also configured to communicate with an array controller **22.** In one embodiment, the array controller **22** includes a row driver circuit **24** and a column driver circuit **26** that provide signals to a pixel array **30.** The cross section of the array illustrated in Figure 1 is shown by the lines 1-1 in Figure 2. For MEMS interferometric modulators, the row/column actuation protocol may take advantage of a hysteresis property of these devices illustrated in Figure 3. It may require, for example, a 10 volt potential difference to cause a movable layer to deform from the relaxed state to the actuated state. However, when the voltage is reduced from that value, the movable layer maintains its state as the voltage drops back below 10 volts. In the exemplary embodiment of Figure 3, the movable layer does not relax completely until the voltage drops below 2 volts. There is thus a range of voltage, about 3 to 7 V in the example illustrated in Figure 3, where there exists a window of applied voltage within which the device is stable in either the relaxed or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be relaxed are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or relaxed pre-existing state. Since each pixel of the interferometric modulator, whether in the actuated or relaxed state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

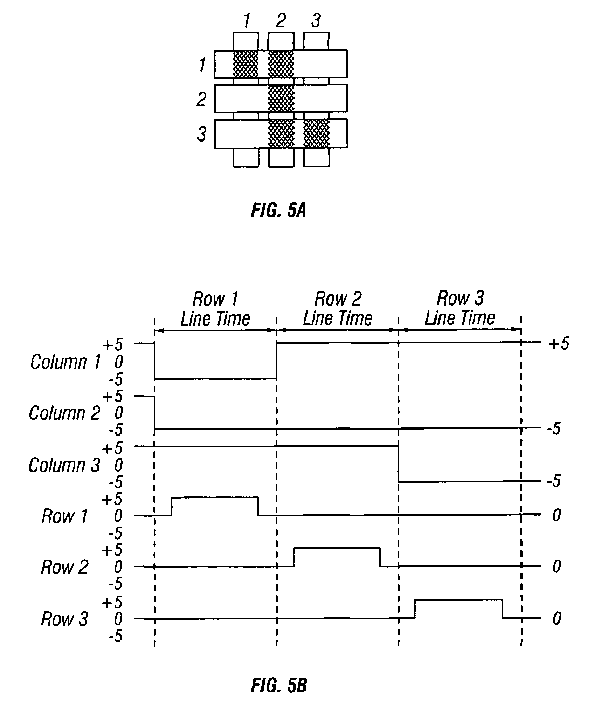

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to-V_{bias}, and the appropriate row to +ΔV, which may correspond to -5 volts and +5 volts respectively Relaxing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or -V_{bias}.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or relaxed states.

In the Figure 5A frame, pixels (1,1), (1,2), (2,2), (3,2) and (3,3) are actuated. To accomplish this, during a "line time" for row 1, columns I and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and relaxes the (1,3) pixel. No other pixels in the array are affected. To set row 2 as desired, column 2 is set to -5 volts, and columns 1 and 3 are set to +5 volts. The same strobe applied to row 2 will then actuate pixel (2,2) andrelax pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

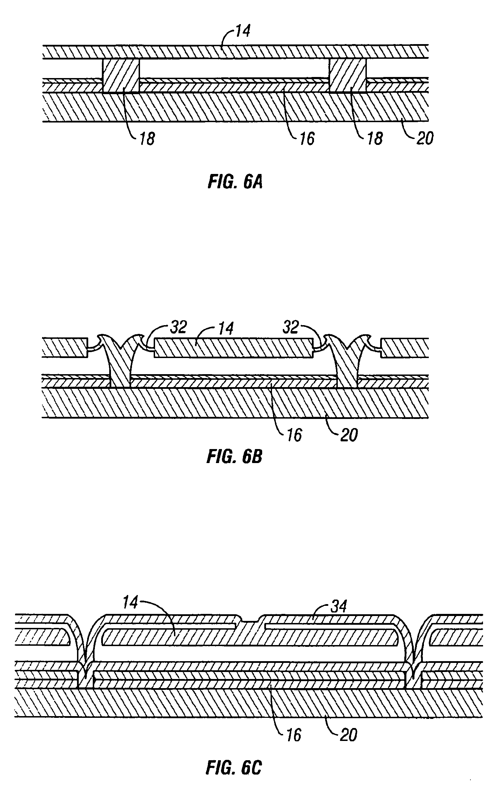

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 1, where a strip of metal material **14** is deposited on orthogonally extending supports **18**. In Figure 6B, the moveable reflective material **14** is attached to supports at the comers only, on tethers **32**. In Figure 6C, the moveable reflective material **14** is suspended from a deformable layer **34**. This embodiment has benefits because the structural design and materials used for the reflective material **14** can be optimized with respect to the optical properties, and the structural design and materials used for the deformable layer **34** can be optimized with respect to desired mechanical properties. The production of various types of interferometric devices is described in a variety of published documents, including, for example, U.S. Application Publication No. 2004/0051929. A wide variety of well known techniques may be used to produce the above described structures involving a series of material deposition, patterning, and etching steps.

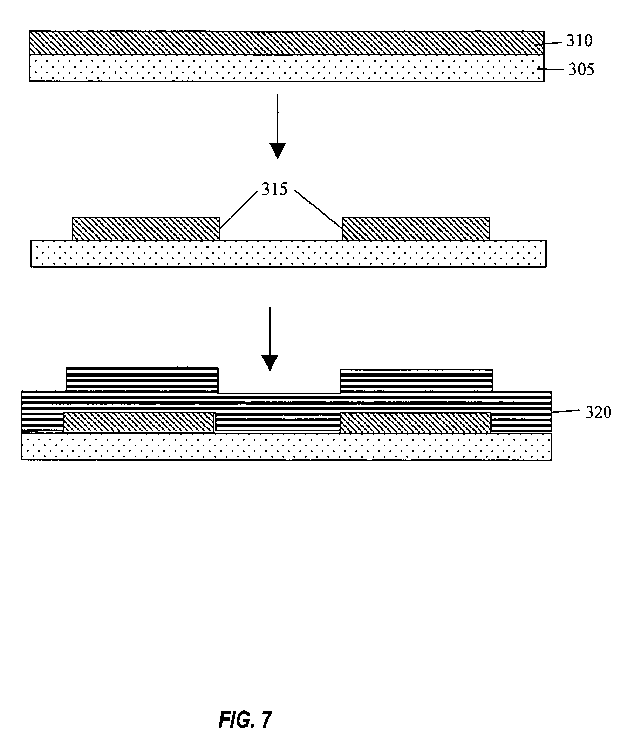

Interferometric modulators of the general design discussed above comprise an interferometric cavity (e.g., cavity **19** in Figures I and 6) and a post structure (e.g., support **18** in Figures 1 and 6), and may be fabricated using the techniques disclosed and/or referenced in U.S. Application Publication No. 2004/0051929. Figures 7-9 schematically illustrate aspects of a fabrication process for an interferometric modulator in which the post structure is formed by depositing a sacrificial layer, forming holes in the sacrificial layer, depositing a polymer in the holes, and later removing the sacrificial layer, leaving the polymer behind to form the posts. Those skilled in the art will appreciate that the fabrication processes described herein may be carried out using conventional semiconductor manufacturing techniques such as photolithography, deposition (e.g., "dry" methods such as chemical vapor deposition (CVD) and wet methods such as spin coating), masking, etching (e.g., dry methods such as plasma etch and wet methods), etc.

Figure 7 illustrates the formation of a first mirror layer **315** by deposition of mirror material **310** on a substrate **305** and subsequent patterning and etching. Figure 7 further illustrates deposition of a dielectric layer **320** over the first mirror layer **315** and the exposed substrate **305**. The mirror material is electrically conductive and may comprise a metal or a semiconductor (such as silicon) doped to have the desired conductivity. In one embodiment, the first mirror layer **315** is a multilayer structure comprising a transparent conductor (such as indium tin oxide) and a primary mirror (such as chromium). In another embodiment, the first mirror layer **315** is a multilayer structure comprising a transparent conductor (such as indium tin oxide), a dielectric layer (silicon oxide) and a primary mirror. In a number of embodiments the first mirror layer (e.g., the first mirror layer **315)** also functions as an electrode, and thus the terms "electrode," "mirror" and "mirror layer" may be used interchangeably herein. The dielectric layer **320** may be silicon oxide.

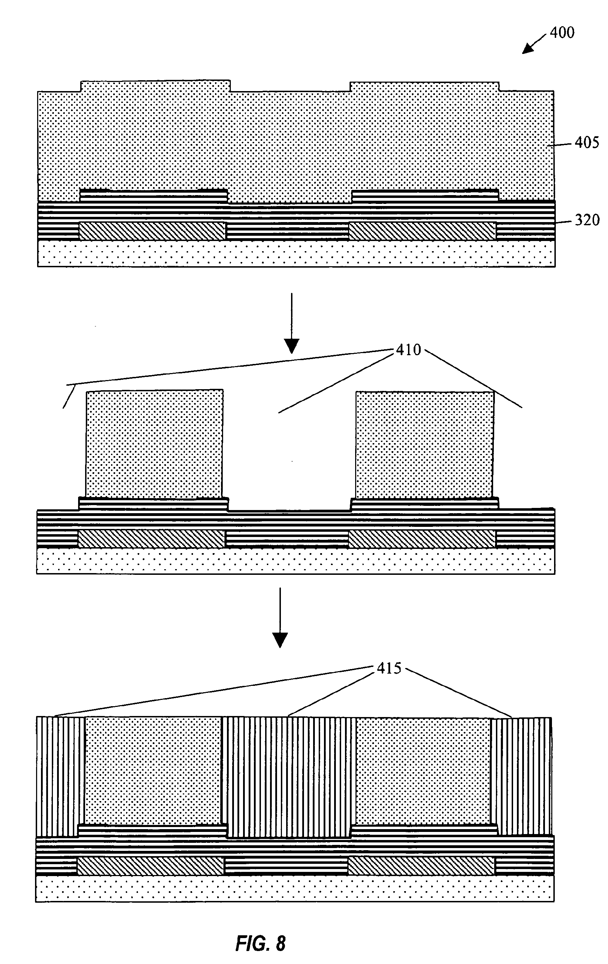

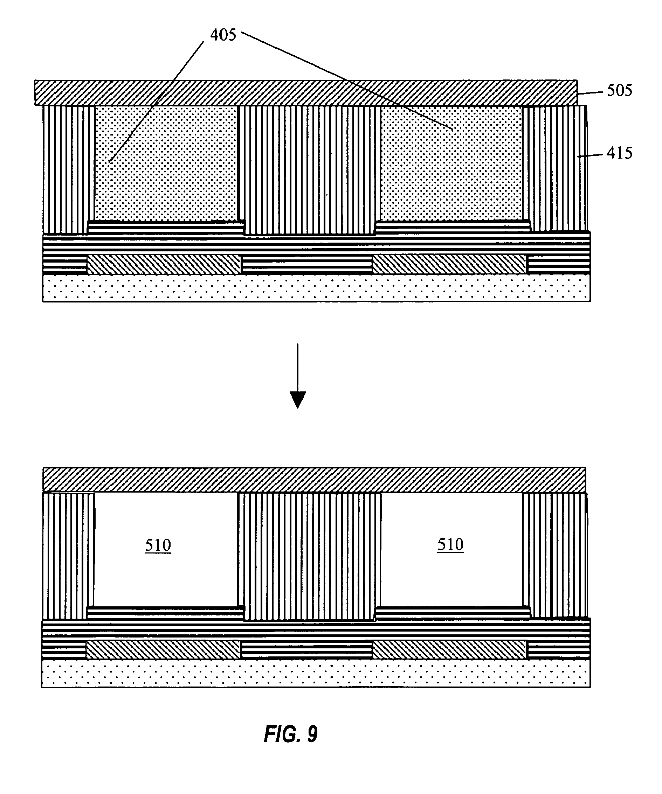

The fabrication process continues as illustrated in Figure 8 by depositing a sacrificial layer **405** over the dielectric layer **320** to form a structure **400,** masking and etching the sacrificial layer **405** to form holes **410,** and depositing a polymer in the holes **410** to form post structures **415.** The sacrificial layer may be a material (such as molybdenum or silicon) that is capable of being etched by exposure to XeF₂ vapor. The polymer may be a negative photoresist material. A second mirror layer **505** is then deposited over the post structures **415** and the sacrificial layer **405** as illustrated in Figure 9. The second mirror layer **505** is electrically conductive and may be a metal or a semiconductor (such as silicon) doped to have the desired conductivity. In alternate process flows (not shown in Figure 9), a multi-step process is used to fabricate a second mirror layer that is suspended from a mechanical layer (e.g., as illustrated in Figure 6C). For embodiments in which the second mirror layer (e.g., the second mirror layer **505**) also functions as an electrode, the terms "electrode," "mirror" and "mirror layer" may be used interchangeably. In the illustrated embodiment, the second mirror layer **505** also has a mechanical function during operation of the resulting interferometric modulator, and thus may be referred to herein as a "mechanical" or "deformable" layer. In other configurations, the mirror layer is suspended from the mechanical or deformable layer, e.g., the mirror **14** may be suspended from the deformable layer **34** as illustrated in Figure 6C. The sacrificial layer **405** is then removed by, e.g., etching, to form an interferometric cavity **510** as illustrated in Figure 9. A molybdenum or silicon sacrificial layer may be removed by exposure to XeF₂ vapor. Those skilled in the art will understand that in the process flow for fabricating an interferometric modulator illustrated in Figures 7-9, the sacrificial layer and post structure are formed from different materials, e.g., molybdenum (sacrificial layer) and polymer photoresist (post structure), that are deposited at different stages of the fabrication process.

An improved process for fabricating an interferometric modulator has now been developed that involves depositing a layer of material over a first mirror layer, forming a second mirror layer over the material, and then selectively removing a sacrificial portion of the layer of material to form a cavity and a post structure. The post structure contains a remaining portion of the material layer that is not removed. In some embodiments, the material that is deposited over the first mirror layer (and then selectively removed to form the cavity and post structure) has substantially uniform composition when initially deposited, but is selectively altered during the fabrication process so that the sacrificial portion is easier to remove than the remaining portion that forms the post structure. Selective removal techniques may be used to facilitate removing the sacrificial portion. In other embodiments, the material has a substantially uniform composition throughout deposition and removal, and selective removal techniques (relative to surrounding materials, such as an overlying mechanical layer and underlying dielectric layer) are applied to remove the sacrificial portion (e.g., by isotropic lateral recessing), leaving the remaining portion behind to form at least part of the posts. Other embodiments provide unreleased MEMS substrates from which the sacrificial portion may be removed as described above. For example, an embodiment provides an unreleased MEMS substrate comprising a material, the MEMS substrate being configured so that a sacrificial portion of the material is removable to form a cavity; and the MEMS substrate being further configured so that a remaining portion of the material forms a post structure of an interferometric modulator upon removal of the sacrificial portion. Another embodiment provides an unreleased MEMS substrate comprising a material and a means for selectively removing a sacrificial portion of the material relative to a remaining portion of the material so that the remaining portion of the material forms a means for supporting an interferometric modulator upon removal of the sacrificial portion. The removing means may comprise, for example, a portion of the material that is selectively altered to define the sacrificial portion of the material and the remaining portion of the material. The removing means may comprise, for example, an overlying layer, e.g., an overlying layer configured so that a remaining portion of an underlying material forms a post structure upon removal of the sacrificial portion, or the removing means may comprise an aperture configured to expose the material to an etchant. The supporting means may comprise, for example, a support structure or post structure. These and other embodiments are described in greater detail below.

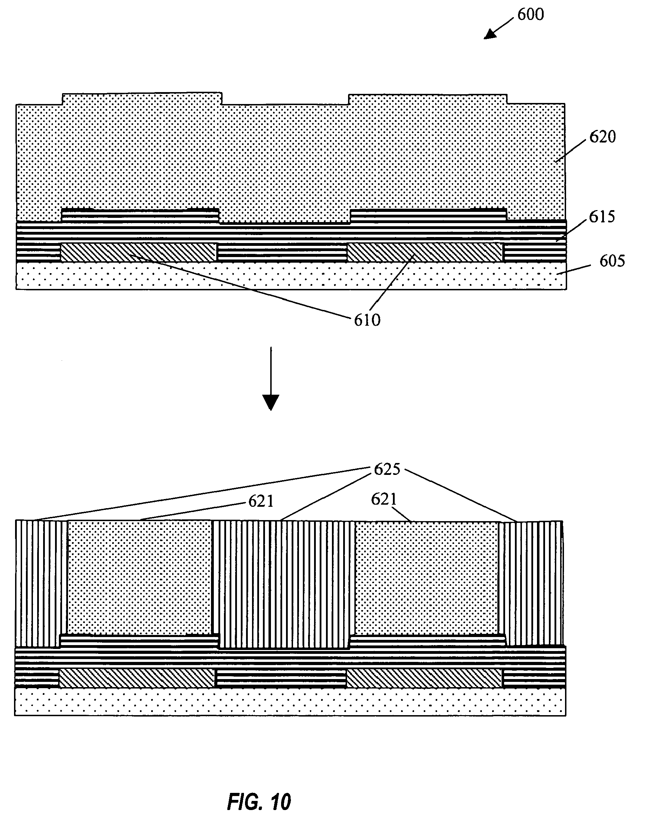

In one embodiment, the material has substantially uniform properties when initially deposited, but is selectively altered during the fabrication process so that the sacrificial portion can be selectively removed relative to the remaining portion that forms the post structure. Such an embodiment is illustrated in Figure 10. The process shown in Figure 10 begins with a structure **600** that includes a substrate **605,** a first mirror layer **610** over the substrate **605,** a dielectric layer **615** over the first mirror layer **610** and the substrate **605,** and a material **620** over the dielectric layer **615.** The structure **600** may be fabricated in the general manner described above with respect to making the structure **400** illustrated in Figure 8, except that the material **620** is a material that is capable of being selectively altered so that a sacrificial portion is selectively removable relative to the unaltered portion of the material. Photosensitive polymers are nonlimiting examples of such materials. Photosensitive polymers include positive photoresists and negative photoresists. Exposure of a positive resist to radiation (e.g., ultraviolet light) alters the polymer so that it becomes easier to remove. Exposure of a negative photoresist to radiation (e.g., ultraviolet light) alters the polymer so that it becomes more difficult to remove. Photosensitive polymers can be selectively irradiated by known techniques (e.g., by masking) so that one or more portions of the polymer are easier to remove than one or more other portions. Silicon is another example of a material that is capable of being selectively altered so that a sacrificial portion is removable. For example, silicon may be selectively altered by ion implantation with oxygen atoms to form silicon oxide(s). Various selective removal chemistries are available to selectively etch silicon oxide(s) relative to silicon and vice versa. Other selective removal chemistries are available for the selective removal of other material systems, e.g., doped vs. undoped silicon, doped vs. undoped silicon oxide(s); nitrided or silicided metal vs. metal, etc. Selective alteration may be conducted by masking a base material (e.g., silicon) and implanting the appropriate ions (e.g., implanting oxygen atoms to form silicon oxide(s)) in the unmasked areas. Preferably, the material **620** is a photoresist that can be patterned using a reticle that blocks light from reaching selected areas of the photoresist during irradiation. The use of such a reticle may reduce or eliminate masking of the base material. Another advantage of photoresists is that they are typically self-planarizing, as they are deposited by spin-on deposition processes.

In the illustrated embodiment, the material **620** is a photosensitive polymer. In Figure 10, the material **620** is selectively irradiated (e.g., by suitable masking, not shown) to form irradiated portions **625** in the selectively irradiated areas and non-irradiated portions **621** remaining in the non-irradiated areas. In this embodiment, the material **620** is a photosensitive polymer that undergoes crosslinking upon irradiation (e.g., a negative photoresist). Such photosensitive polymers are well known to those skilled in the art. The crosslinking hardens the polymer to form the irradiated portions **625,** so that the remaining non-irradiated portions **621** may be selectively removed during a later stage of the process as described below. In other arrangements, the resist may contain photo acid generators (PAGs) activated by exposure to light, rendering the resulting acidic or non-acidic regions selectively removable relative to the other regions.

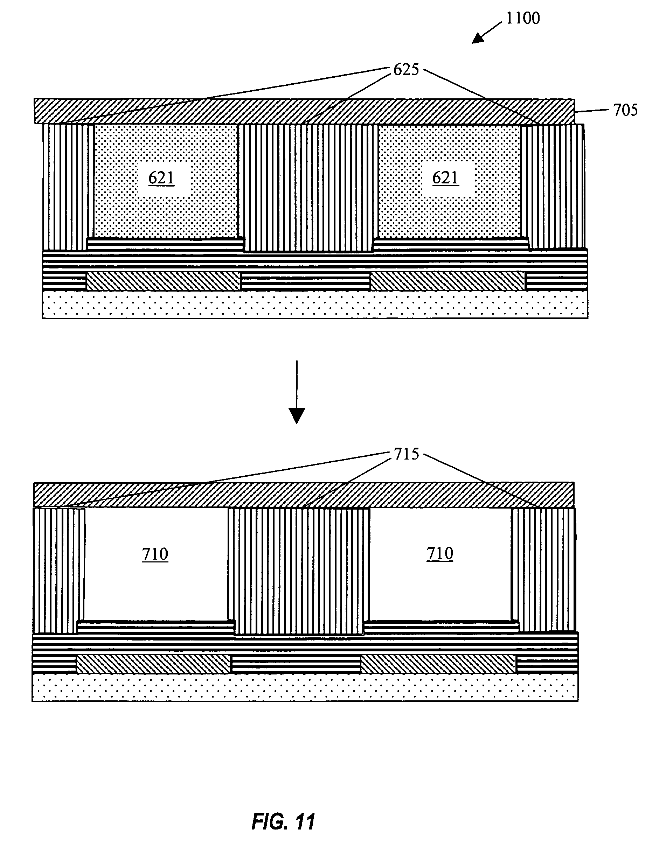

Figure 11 shows a second mirror layer **705** is then formed over the irradiated portions **625** and the non-irradiated portions **621** to form an unreleased interferometric modulator substrate **1100.** In this embodiment, the second mirror layer **705** has a mechanical function and may be referred to as a mechanical or deformable layer. The second mirror layer **705** may be formed by known deposition techniques, e.g., sputtering or chemical vapor deposition. An optional planarization step may be used to planarize the upper parts of the irradiated portions **625** and the non-irradiated portions **621,** thus providing a relatively flat surface to underlie the second mirror layer **705.** The second mirror layer **705** is electrically conductive and may be a metal or a semiconductor (such as silicon) doped to have the desired conductivity. In this embodiment, the second mirror layer **705** is an electrode. In alternate process flows (not shown in Figure 11), a multi-step process is used to fabricate a second mirror/electrode that is suspended from a mechanical layer (e.g., as illustrated in Figure 6C).

The non-irradiated portions **621** of the unreleased substrate **1100** are then removed to form interferometric modulator cavities **710** as illustrated in Figure 11. The polymer in the irradiated portions **625** has been hardened by crosslinking and thus has a different solubility that the non-irradiated portions **621.** Crosslinking can be performed using various forms of energy, e.g., UV, ionizing radiation, heat, etc. Thus, for example, by employing the appropriate etch chemistry, the non-irradiated portions **621** may be selectively removed to form the cavities **710,** leaving behind the polymer remaining in the irradiated portions **625** to form post structures **715.** In the illustrated embodiment, selective removal of the non-irradiated portions **621** is accomplished by washing with a liquid solvent that preferentially dissolves the uncrosslinked polymer in the non-irradiated portions **621.** In alternate embodiments, removal may be accomplished by exposure to a plasma or chemical vapor that preferentially etches the non-irradiated portions **621.**

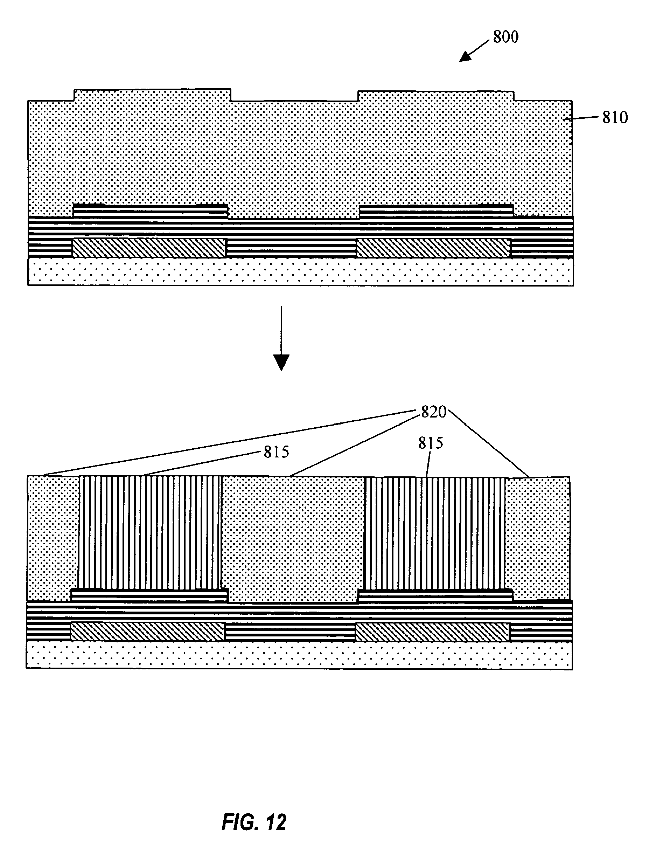

In another embodiment, illustrated in Figure 12, a structure **800** is formed in the same general manner as the structure **600** illustrated in Figure 10, except that a photosensitive polymer **810** is selected that undergoes degradation upon irradiation (e.g., a positive photoresist) to form irradiated portions **815** in the selectively irradiated areas and non-irradiated portions **820** remaining in the non-irradiated areas. Such selective irradiation may be accomplished by e.g., reversing the masking illustrated in Figure 10. The fabrication process may then be continued (not shown in Figure 12) in the general manner described above with respect to Figure 11, by depositing a second mirror layer and then selectively removing the degraded polymer in the irradiated portions **815** to form cavities, leaving behind the polymer in the non-irradiated portions **820** to form post structures.

The processes illustrated in Figures 10-12 may also be carried out using other materials that can be selectively altered so that the altered portions are selectively removable relative to the unaltered portions. For example, those skilled in the art will understand that silicon can be selectively altered by oxygen ion implantation through a suitable mask to form silicon oxide(s) in selected area(s). Selective removal of a sacrificial portion (either the unaltered silicon or the silicon oxide) may then be conducted using a suitable etchant to form a cavity and a post structure in the general manner illustrated in Figures 10-12, such that the post structure comprises a remaining portion of the silicon or silicon oxide(s). Other material systems and selective removal chemistries may also be used as discussed above. Those skilled in the art will also understand that the order of the process steps illustrated in Figures 10-12 may be changed as desired. For example, alteration of the material **620** by selective irradiation to form irradiated portions **625** in the selectively irradiated areas and non-irradiated portions **621** remaining in the non-irradiated areas as illustrated in Figure 10 may be conducted prior to forming the second **mirror 705** (as illustrated in Figure 11). In an alternate embodiment (not illustrated), the material **620** is selectively irradiated after the second mirror **705** is formed over the material **620.**

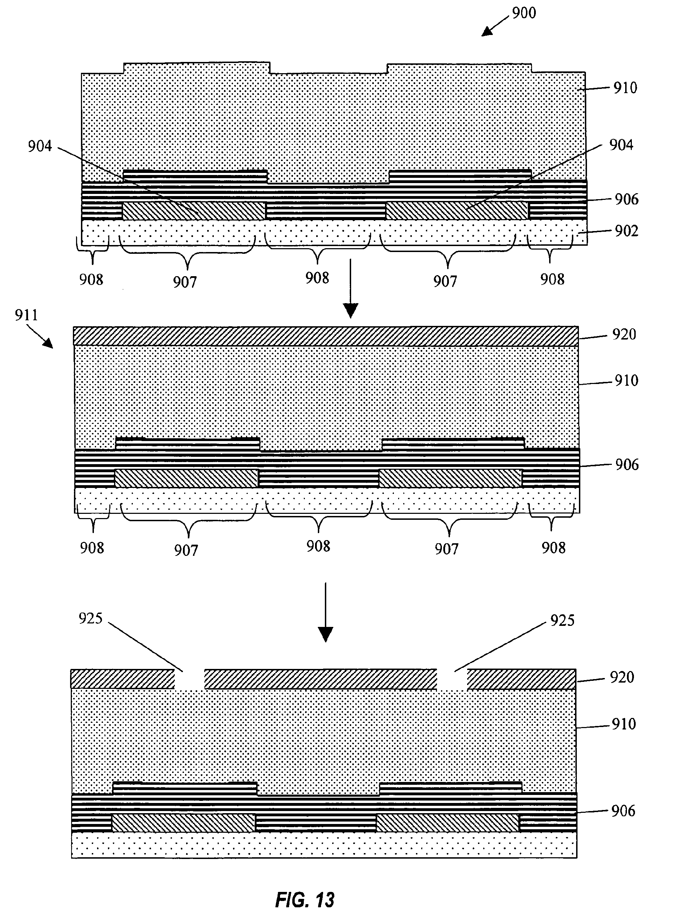

In other embodiments, the material deposited over the first mirror layer has substantially uniform properties throughout deposition and removal, and removal techniques are applied to remove sacrificial portions of the material, leaving remaining portions of the material behind to form at least part of the posts. The removal techniques are selective between the material and other surrounding materials but non-selective between the sacrificial and remaining portions of the material. The process flow shown in Figures 13-14 illustrates such an embodiment. The process begins in Figure 13 with a structure **900** that includes a substrate **902,** a first mirror layer **904** over the substrate **902,** a dielectric layer **906** over the first mirror layer **904** and the substrate **902,** and a material layer **910** over the dielectric layer **906.** The substrate **902** includes a first area **907** configured to underlie the first mirror layer **904** and a second area **908** configured to underlie a post structure that will be formed as described below.

The structure **900** may be fabricated in the same general manner as described above with respect to making the structure **400** illustrated in Figure 8. The material **910** is a material that is capable of being selectively etched relative to other surrounding materials (e.g., the first mirror layer **904** and the dielectric layer **906)** by exposure to a suitable etchant to remove a sacrificial portion. Molybdenum and silicon are examples of such materials and XeF₂ is an example of a suitable etchant. Those skilled in the art understand that, in this context, the term "XeF₂ etchant" refers to the gaseous and/or vaporous substance formed by the sublimation of solid XeF₂, and may include XeF₂, Xe and F₂ in gaseous or vapor form. The material **910** is molybdenum in the illustrated embodiment.

The process illustrated in Figure 13 continues by forming a second mirror layer **920** over the molybdenum layer **910** and over the first area **907** to form an unreleased interferometric modulator substrate **911.** In the illustrated embodiment, the second mirror layer **920** is also formed over the second area **908.** In a prior intermediate step (not shown), the molybdenum layer **910** was planarized. Such planarization is optional. Those skilled in the art will understand that, in the illustrated embodiment, the second mirror **layer 920** also functions as a mechanical layer and as an electrode in the resulting interferometric modulator, and thus may be referred to as a mechanical layer, deformable layer and/or electrode herein. The process continues by forming vias **925** through the second mirror layer **920** to expose the molybdenum layer **910.** The vias **925** are formed in the second mirror layer **920** over areas of the structure **900** in which the creation of optical cavities is desired (e.g., over the first area **907),** as explained in greater detail below. The vias **925** may be formed by masking and etching techniques known to those skilled in the art.

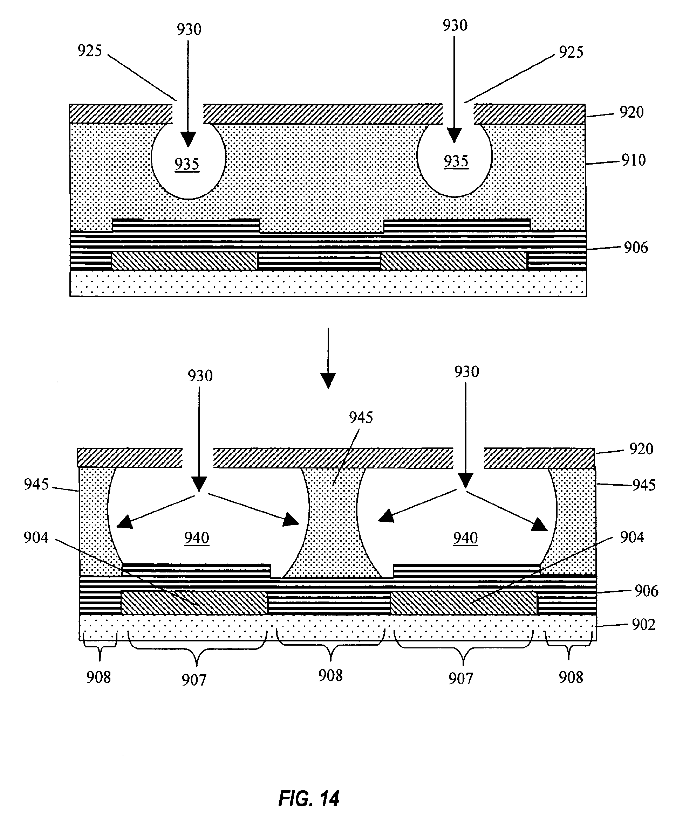

The process continues as illustrated in Figure 14 by introducing a XeF₂ etchant **930** through the vias **925** to isotropically selectively etch the molybdenum layer **910** without substantially etching the dielectric layer **906** or the second mirror layer **920.** Other selective etchants may also be suitable, depending on the nature of the material **910** and the materials used to form the dielectric layer **906** and the second mirror layer **920,** as well as the exigencies of production. In the illustrated embodiment, etching of the molybdenum layer **910** by the etchant **930** proceeds by forming cavities **935** that laterally undercut the second mirror layer **920** and expand in size to form optical cavities **940** over the course of the etching process. The vias **925** are positioned and the etching conditions are selected so that the etchant**930** removes a sacrificial portion of the material layer **910** under the second mirror layer **920** to form the optical cavities **940** over the first area **907** and over the first mirror **904,** and so that the remaining portion of the material layer **910** forms post structures **945** that provide support to the second mirror layer **920** over the second area **908.** Optionally, production may continue to finish making a MEMS device such as an interferometric modulator. In the illustrated embodiment, the post structures**945** have a re-entrant profile that is generally concave in cross-section. Those skilled in the art will understand that the base of the post structures **945** may be wider than the top, as shown. In the illustrated embodiment, the etchant enters through the **vias 925** and thus there tends to be more etching near the top than the bottom, resulting in post structures **925** that tend to be wider at the bottom than at the top.

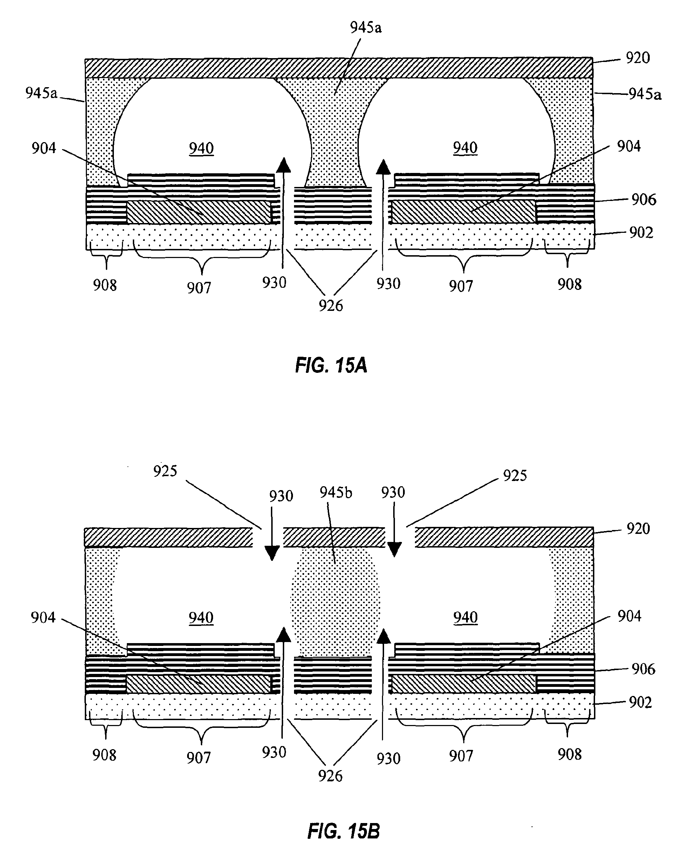

Figure 15A illustrates another embodiment in which the etchant **930** enters through apertures **926** formed through the substrate **902**, in which case there tends to be more etching near the bottom than the top as shown for the post structure **945a**. In still another embodiment illustrated in Figure 15B, the etchant **930** enters through both the vias **925** and the apertures **926,** in which case there tends to be more etching near the top and the bottom of the post structure than in the middle, as indicated by the convex cross-section of the post structure **945b** in the illustrated embodiment.

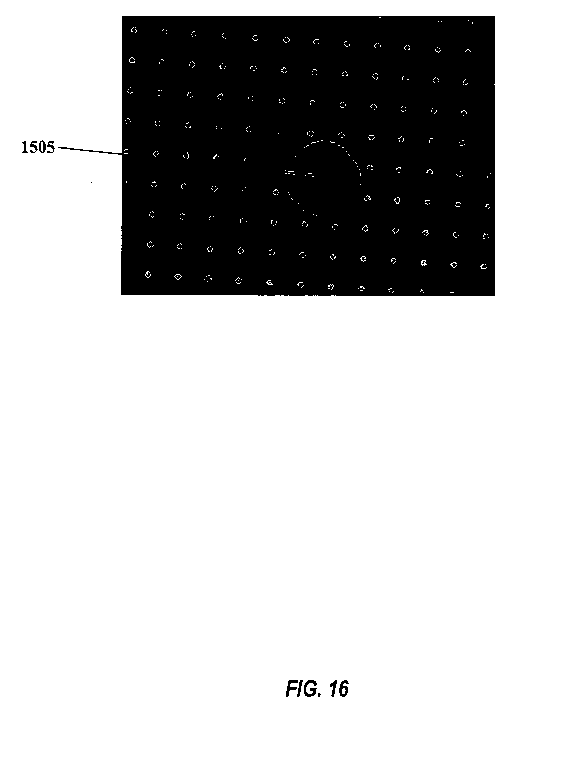

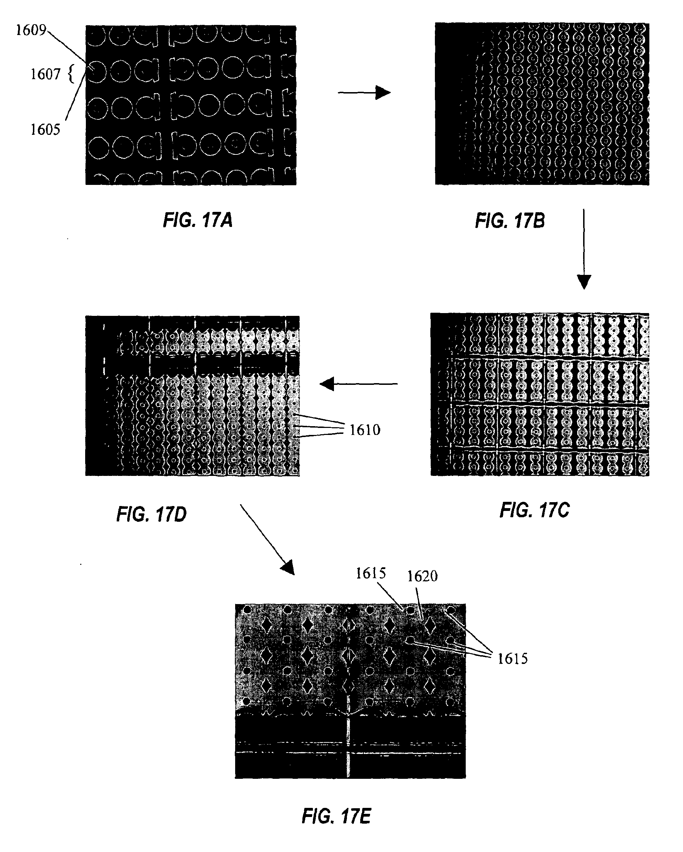

The positioning of the vias **925** and the selection of the etching conditions to produce cavities and post structures as illustrated in Figures 13-15 may be accomplished in various ways. Figure 16 shows a photomicrograph of an interferometric modulator substrate (taken from the display side) after a controlled amount of a XeF₂ etchant was introduced through a via **1505** to etch a molybdenum material. The photomicrograph shows that the XeF₂ flows through the via **1505** and then etches the molybdenum in a generally radial pattern to form a cavity (the cross section is not seen here). This flow pattern may be utilized to produce an array of interferometric modulator cavities and post structures as illustrated by the series of photomicrographs shown in Figure 17.

Figure 17A shows an array of cavities (including a cavity **1605)** having generally circular cross-sections in the molybdenum material of an interferometric modulator substrate, resulting from a "timed etch" involving the introduction of a XeF₂ etchant through a corresponding array of vias (e.g., a via **1609).** The photomicrograph shown in Figure 17A was taken about one minute after the XeF₂ etchant was introduced through the vias (e.g., the via **1609).** Figures 17B, 17C, 17D and 17E show photomicrographs of different interferometric modulator substrates exposed to the XeF₂ etchant for various periods of time. The etched substrates shown in Figures 17B-17E illustrate the effect of introducing the XeF₂ etchant through the vias **1609, 1610,** and **1615** to thereby etch the molybdenum material for about two, four, six, and eight minutes, respectively. Those skilled in the art will understand that different reference numbers are used to refer to the vias in Figures 17A, 17D and 17E because different interferometric modulator substrates (and thus different vias) are illustrated in the series of representative photomicrographs. The diameter of the vias was about 4 microns (um) and the chamber pressure was in the range of about 20 mTorr to 2 Torr during the etching processes illustrated in Figure 17. The series of photomicrographs in Figure 17 illustrates the manner in which the diameters of the cavities would tend to increase as etching proceeds, from the initial stages in which the edges of the cavities (e.g., cavity edges **1607)** are separated from one another to the later stages, when the cavity edges meet and merge. By stopping the etching after the cavity edges merge but prior to complete removal of the molybdenum material, remaining material is left behind to form posts. For example, the diamond-shaped post **1620** in Figure 17E may be formed by introducing XeF₂ etchant through the vias **1615** until the corresponding cavities merge.

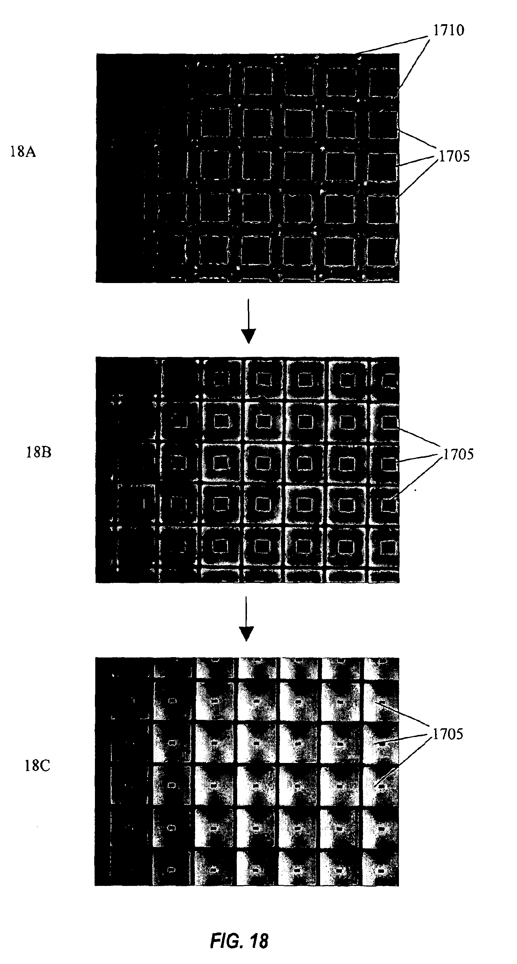

Figure 18 illustrates a progression of representative photomicrographs illustrating the formation of interferometric modulator posts **1705** by introducing a XeF₂ etchant through a series of horizontal and vertical vias **1710.** The vias **1710** are openings or channels in the overlying or covering layer(s), exposing the underlying molybdenum material. In Figure 18A, the interferometric modulator substrate was exposed to XeF₂ vapor for about 30 seconds. In Figure 18B, the exposure to XeF₂ was for about 45 seconds, and in Figure 18C, the exposure to XeF₂ was for about one minute. The etching rate may be adjusted as desired by controlling the chamber pressure and/or introducing the XeF₂ gas to the chamber in admixture with other gas(es), e.g., in admixture with a carrier gas such as nitrogen, helium, xenon, and/or argon. Those skilled in the art will understand that apertures (including arrays of apertures) in the overlying layer and/or the substrate are preferably configured to facilitate both etching of the material layer to form the cavity and post structure, and operation of the resulting MEMS device. Thus, for example, it is preferred that apertures in the mirror layer of an interferometric modulator be configured to minimize any negative impact on the functioning of the mirror layer. Routine experimentation may be used to identify optimum aperture configurations and etching conditions.

Those skilled in the art will understand that the process embodiments illustrated in Figures 13-18 may also be practiced using materials that can be selectively altered so that the altered portions are rendered selectively more or less removable relative to the unaltered portions. For example, the unreleased interferometric modulator substrate **1100** illustrated in Figure 11 may be used in place of the unreleased interferometric modulator substrate **911** illustrated in Figure 13. In such a case, the vias **925** formed through the second mirror layer **920** to expose the molybdenum layer **910** (as illustrated in Figure 13) would instead be formed through the second mirror layer **705** to expose the non-irradiated portions **621** of unreleased interferometric modulator substrate **1100.** Removal of the non-irradiated portions **621** could then be conducted in the same general manner as illustrated in Figure 14 and described above, with the added advantage of a wider processing window (e.g., because less risk of over-etching of irradiated portions **625** after removal of non-irradiated portions **621).**

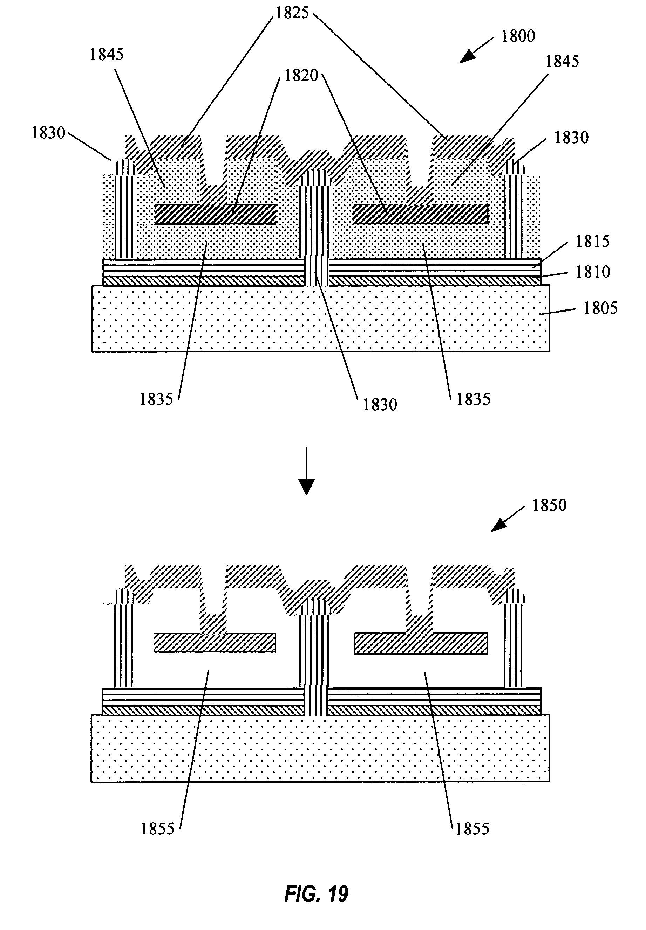

The processes described herein are also applicable to the manufacture of unreleased and released interferometric modulators of the general type illustrated in Figure 6C, in which a second mirror layer (the moveable reflective material **14)** is suspended from a deformable layer **34.** Interferometric modulators of the general type illustrated in Figure 6C may be fabricated as described in U.S. Patent Publication No. 2004/0051929 A1. Aspects of a method for fabricating interferometric modulators of the general type illustrated in Figure 6C are illustrated by the schematic cross-sectional views shown in Figure 19. An unreleased interferometric modulator **1800** includes a substrate **1805,** a first mirror layer **1810** over the substrate **1805,** a dielectric layer **1815** over the first mirror layer **1810,** and a first portion of sacrificial material **1835** over the dielectric layer **1815.** A second mirror layer **1820** is formed over a portion of the sacrificial material **1835,** and a second portion of sacrificial material **1845** is formed over the second mirror layer **1820.** The second mirror layer **1820** is attached to a deformable or mechanical layer **1825** formed over the second portion of sacrificial material **1845.** Posts **1830** are formed through vias in the first and second portions of the sacrificial material **1835, 1845.** The posts **1830** are configured to support the mechanical layer **1825** after the sacrificial material **1835, 1845** is removed. Exposure of the sacrificial material **1835, 1845** to an etchant results in the formation of a released interferometric modulator **1850** having interferometric cavities **1855** as illustrated in Figure 19. After such removal, the second mirror layer **1820** is suspended from the deformable or mechanical layer **1825.**

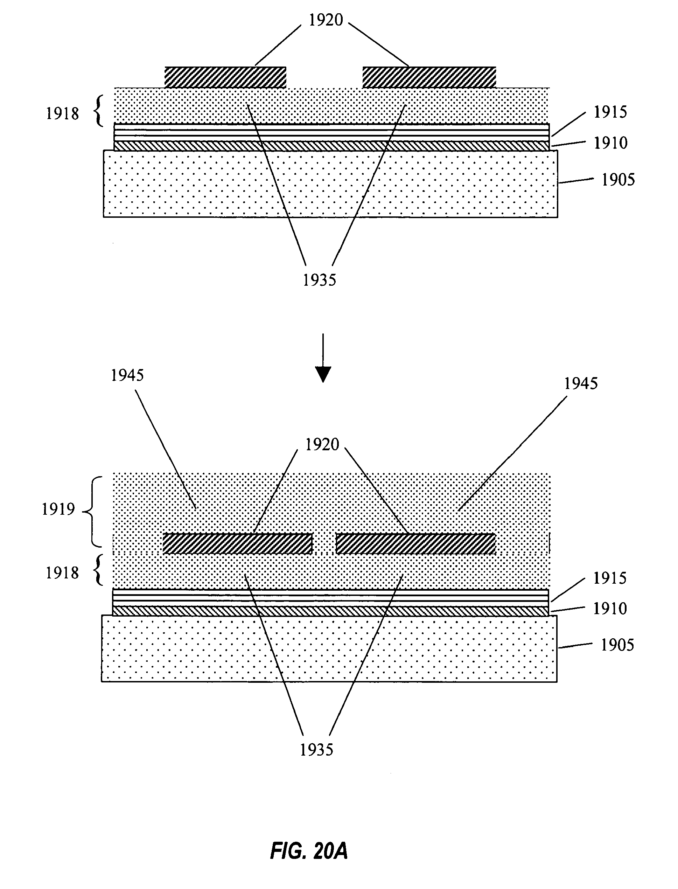

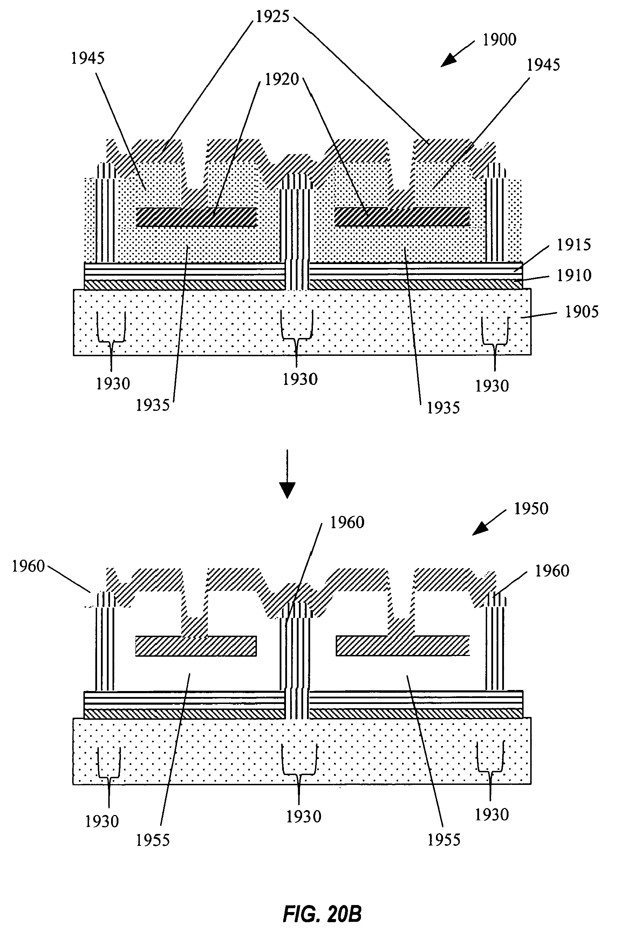

Using variants of the process described above and illustrated in Figures 7-9, interferometric modulators of the general type illustrated in Figure 19 may be fabricated by methods known to those skilled in the art by using different materials to form the posts1830 and the sacrificial material **1835, 1845.** In an embodiment, it has now been found that interferometric modulators of the general type illustrated in Figure 19 may also be fabricated by depositing a material over a first mirror layer; forming a second mirror layer over the material; and selectively removing a sacrificial portion of the material to thereby form a cavity and a post structure of the interferometric modulator, the post structure comprising a remaining portion of the material. Aspects of such an embodiment are illustrated in Figure 20.

Figure 20B shows a cross-sectional schematic view of an unreleased interferometric modulator substrate **1900** that includes a substrate **1905,** a first mirror layer **1910** over the substrate **1905,** a dielectric layer **1915** over the first mirror layer **1910,** and a lower portion of a material **1935** over the dielectric layer **1915.** A second mirror layer **1920** is formed over the lower portion of the material **1935,** and an upper portion of the material **1945** is formed over the second mirror layer **1920.** The second mirror layer **1920** is attached to a deformable or mechanical layer **1925** formed over the upper portion of material **1945.** The upper and lower portions of the material **1935, 1945** are also formed over areas **1930** of the substrate **1905** configured to underlie support posts which will be formed as described below. In the illustrated embodiment, the upper and lower portions of the material **1935, 1945** comprise a negative photoresist that is altered when exposed to radiation (e.g., ultraviolet light). Aspects of a process for making the unreleased interferometric modulator substrate **1900** are illustrated in Figure 20A and include forming the first mirror layer **1910** and dielectric layer **1915** on the substrate **1905,** depositing a photoresist layer **1918** over the dielectric layer **1915,** then forming the second mirror layer **1920** over the photoresist layer **1918** by patterning and etching. The photoresist layer **1918** includes the lower portion of the material **1935** under the second mirror layer **1920.** A photoresist layer **1919** is then deposited over the photoresist layer **1918** and over the second mirror layer **1920.** The photoresist layer **1919** includes the upper portion of the material **1945** over the second mirror layer **1920.** The photoresist layer **1919** is then masked and etched to form vias.

As illustrated in Figure 20B, the unreleased interferometric modulator substrate **1900** is suitably exposed to ultraviolet radiation through a reticle and the upper and lower portions of the material **1935, 1945** that are over the areas **1930** of the substrate **1905** are altered by exposure to ultraviolet light. The upper and lower portions of the material **1935, 1945** that are not over the areas **1930** of the substrate **1905** (including the lower portion of the material **1935** underlying the second mirror layer **1920** and the upper portion of the material **1945** overlying the second mirror layer **1920)** are not exposed to ultraviolet light and thus form sacrificial material. The mechanical layer **1925** is then formed and attached to the second mirror layer **1920.** The sacrificial material is then removed (e.g., by washing with a suitable solvent) to form cavities **1955.** The altered upper and lower portions of the material **1935, 1945** over the areas **1930** remain and form posts **1960** that directly support the mechanical layer **1925** and indirectly support the second mirror layer **1920,** resulting in a released interferometric modulator **1950.**

Those skilled in the art will understand that interferometric modulators of the general type illustrated in Figure 6C may also be fabricated using variants of the method illustrated in Figure 20. For example, in an embodiment, the material **1935, 1945** may comprise a positive photoresist, in which case the pattern of exposure to irradiation through the reticle is reversed in a manner similar to that described above for the embodiment illustrated in Figure 12. In another exemplary embodiment, the material **1935, 1945** comprises silicon, and is selectively altered by oxygen ion implantation to form a silicon oxide in a manner similar to that described above for the embodiment illustrated in Figure 10. Thus, for example, the silicon may be removed to form a cavity, e.g., by selectively etching against the silicon oxide, leaving the remaining silicon oxide to form a post. In another exemplary embodiment, selective etching techniques similar to those described above for the embodiments illustrated in Figures 13-18 are applied to the material **1935, 1945,** including optional alteration of the material prior to such selective etching to make the sacrificial portions selectively etchable relative to the portions that remain behind to form the posts.

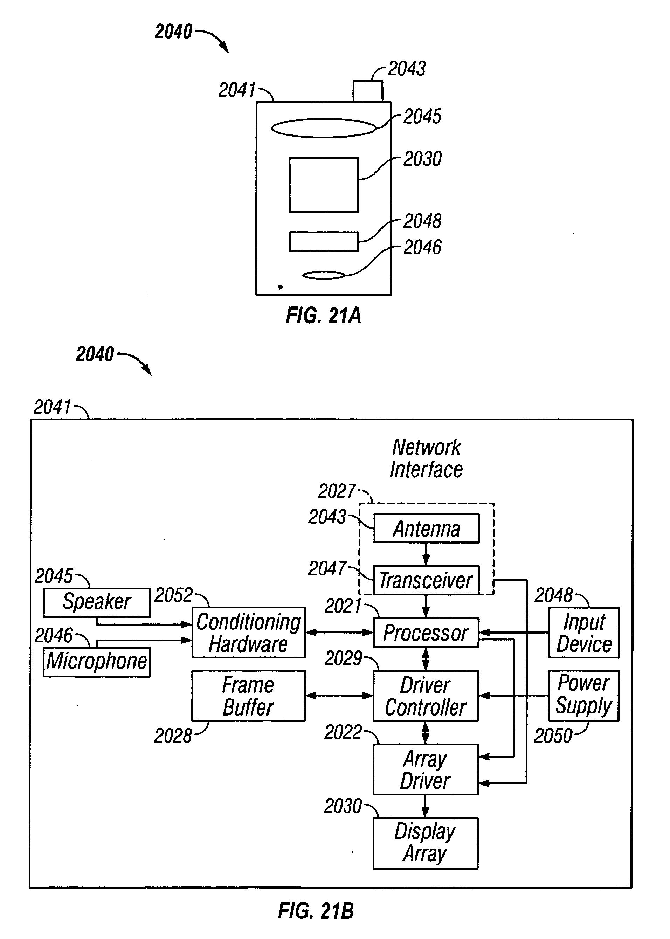

Figures 21A and 21B are system block diagrams illustrating an embodiment of a display device 2040. The display device 2040 can be, for example, a cellular or mobile telephone. However, the same components of display device 2040 or slight variations thereof are also illustrative of various types of display devices such as televisions and portable media players.

The display device 2040 includes a housing 2041, a display 2030, an antenna 2043, a speaker 2045, an input device 2048, and a microphone 2046. The housing 2041 is generally formed from any of a variety of manufacturing processes as are well known to those of skill in the art, including injection molding, and vacuum forming. In addition, the housing 2041 may be made from any of a variety of materials, including but not limited to plastic, metal, glass, rubber, and ceramic, or a combination thereof. In one embodiment the housing 2041 includes removable portions (not shown) that may be interchanged with other removable portions of different color, or containing different logos, pictures, or symbols.

The display 2030 of exemplary display device 2040 may be any of a variety of displays, including a bi-stable display, as described herein. In other embodiments, the display 2030 includes a flat-panel display, such as plasma, EL, OLED, STN LCD, or TFT LCD as described above, or a non-flat-panel display, such as a CRT or other tube device, as is well known to those of skill in the art. However, for purposes of describing the present embodiment, the display 2030 includes an interferometric modulator display, as described herein.

The components of one embodiment of exemplary display device 2040 are schematically illustrated in Figure 21B. The illustrated exemplary display device 2040 includes a housing 2041 and can include additional components at least partially enclosed therein. For example, in one embodiment, the exemplary display device 2040 includes a network interface 2027 that includes an antenna 2043 which is coupled to a transceiver 2047. The transceiver 2047 is connected to the processor 2021, which is connected to conditioning hardware 2052. The conditioning hardware 2052 may be configured to condition a signal (e.g. filter a signal). The conditioning hardware 2052 is connected to a speaker 2045 and a microphone 2046. The processor 2021 is also connected to an input device 2048 and a driver controller 2029. The driver controller 2029 is coupled to a frame buffer 2028 and to the array driver 2022, which in turn is coupled to a display array 2030. A power supply 2050 provides power to all components as required by the particular exemplary display device 2040 design.

The network interface 2027 includes the antenna 2043 and the transceiver 2047 so that the exemplary display device 2040 can communicate with one or more devices over a network. In one embodiment the network interface 2027 may also have some processing capabilities to relieve requirements of the processor 2021. The antenna 2043 is any antenna known to those of skill in the art for transmitting and receiving signals. In one embodiment, the antenna transmits and receives RF signals according to the IEEE 802.11 standard, including IEEE 802.11(a), (b), or (g). In another embodiment, the antenna transmits and receives RF signals according to the BLUETOOTH standard. In the case of a cellular telephone, the antenna is designed to receive CDMA, GSM, AMPS or other known signals that are used to communicate within a wireless cell phone network. The transceiver 2047 pre-processes the signals received from the antenna 2043 so that they may be received by and further manipulated by the processor 2021. The transceiver 2047 also processes signals received from the processor 2021 so that they may be transmitted from the exemplary display device 2040 via the antenna 2043.

In an alternative embodiment, the transceiver 2047 can be replaced by a receiver. In yet another alternative embodiment, network interface 2027 can be replaced by an image source, which can store or generate image data to be sent to the processor 2021. For example, the image source can be a digital video disc (DVD) or a hard-disc drive that contains image data, or a software module that generates image data.

Processor 2021 generally controls the overall operation of the exemplary display device 2040. The processor 2021 receives data, such as compressed image data from the network interface 2027 or an image source, and processes the data into raw image data or into a format that is readily processed into raw image data. The processor 2021 then sends the processed data to the driver controller 2029 or to frame buffer 2028 for storage. Raw data typically refers to the information that identifies the image characteristics at each location within an image. For example, such image characteristics can include color, saturation, and gray-scale level.

In one embodiment, the processor 2021 includes a microcontroller, CPU, or logic unit to control operation of the exemplary display device 2040. Conditioning hardware 2052 generally includes amplifiers and filters for transmitting signals to the speaker 2045, and for receiving signals from the microphone 2046. Conditioning hardware 2052 may be discrete components within the exemplary display device 2040, or may be incorporated within the processor 2021 or other components.

The driver controller 2029 takes the raw image data generated by the processor 2021 either directly from the processor 2021 or from the frame buffer 2028 and reformats the raw image data appropriately for high speed transmission to the array driver 2022. Specifically, the driver controller 2029 reformats the raw image data into a data flow having a raster-like format, such that it has a time order suitable for scanning across the display array 2030. Then the driver controller 2029 sends the formatted information to the array driver 2022. Although a driver controller 2029, such as a LCD controller, is often associated with the system processor 2021 as a stand-alone Integrated Circuit (IC), such controllers may be implemented in many ways. They may be embedded in the processor 2021 as hardware, embedded in the processor 2021 as software, or fully integrated in hardware with the array driver 2022.

Typically, the array driver 2022 receives the formatted information from the driver controller 2029 and reformats the video data into a parallel set of waveforms that are applied many times per second to the hundreds and sometimes thousands of leads coming from the display's x-y matrix of pixels.

In one embodiment, the driver controller 2029, array driver 2022, and display array 2030 are appropriate for any of the types of displays described herein. For example, in one embodiment, driver controller 2029 is a conventional display controller or a bi-stable display controller (e.g., an interferometric modulator controller). In another embodiment, array driver 2022 is a conventional driver or a bi-stable display driver (e.g., an interferometric modulator display). In one embodiment, a driver controller 2029 is integrated with the array driver 2022. Such an embodiment is common in highly integrated systems such as cellular phones, watches, and other small area displays. In yet another embodiment, display array 2030 is a typical display array or a bi-stable display array (e.g., a display including an array of interferometric modulators).

The input device 2048 allows a user to control the operation of the exemplary display device 2040. In one embodiment, input device 2048 includes a keypad, such as a QWERTY keyboard or a telephone keypad, a button, a switch, a touch-sensitive screen, a pressure- or heat-sensitive membrane. In one embodiment, the microphone 2046 is an input device for the exemplary display device 2040. When the microphone 2046 is used to input data to the device, voice commands may be provided by a user for controlling operations of the exemplary display device 2040.

Power supply 2050 can include a variety of energy storage devices as are well known in the art. For example, in one embodiment, power supply 2050 is a rechargeable battery, such as a nickel-cadmium battery or a lithium ion battery. In another embodiment, power supply 2050 isa renewable energy source, a capacitor, or a solar cell, including a plastic solar cell, and solar-cell paint. In another embodiment, power supply 2050 is configured to receive power from a wall outlet.

In some implementations control programmability resides, as described above, in a driver controller which can be located in several places in the electronic display system. In some cases control programmability resides in the array driver 2022. Those of skill in the art will recognize that the above-described optimization may be implemented in any number of hardware and/or software components and in various configurations.

While the above detailed description has shown, described, and pointed out novel features of the invention as applied to various embodiments, it will be understood that various omissions, substitutions, and changes in the form and details of the device or process illustrated may be made by those skilled in the art without departing from the spirit of the invention. As will be recognized, the present invention may be embodied within a form that does not provide all of the features and benefits set forth herein, as some features may be used or practiced separately from others.

## Claims

1. A method for making a MEMS device comprising:
depositing a material over a first electrode layer;
depositing a second layer over the material, the second layer comprising an opening formed therethrough, the opening being configured to expose the material;
flowing an etchant through the opening; and
etching the material to remove a sacrificial portion of the material to thereby form a cavity and a support structure of the MEMS device, the support structure comprising a remaining portion of the material, the etching being non-selective between the sacrificial portion and the remaining portion of the material.

2. The method of Claim 1, wherein the MEMS device comprises an interferometric modulator.

3. The method of Claim 1, wherein the material comprises molybdenum or silicon.

4. The method of Claim 1, wherein the etching of the material is selective against the second layer.

5. The method of Claim 1, wherein the etching comprises laterally recessing the material away from the opening.

6. The method of Claim 1, wherein the etching is isotropic etching.

7. The method of Claim 1, wherein the etchant comprises XeF₂.

8. The method of Claim 1, further comprising etching the second layer to form the opening.

9. The method of Claim 1, wherein the first electrode layer comprises a first mirror.

10. The method of Claim 9, wherein the second layer comprises a second electrode.

11. The method of Claim 10, wherein the second layer further comprises a second mirror.

12. The method of Claim 1, wherein the second layer comprises a mechanical layer.

13. The method of Claim 12, further comprising depositing a mirror layer, at least a portion of which is suspended from the mechanical layer after etching to remove the sacrificial portion of the material.

14. The method of Claim 13, wherein the etching to remove the sacrificial portion is selective against the mirror layer.

15. The method of Claim 13, wherein the support structure comprises a post structure having a re-entrant profile.

16. A MEMS device comprising means for selectively removing a sacrificial portion of a material relative to a remaining portion of the material; and means for supporting at least a portion of an interferometric modulator, the supporting means being formed upon removal of the sacrificial portion, the remaining portion and the sacrificial portion having substantially uniform properties.

17. The MEMS device of Claim 16, wherein the material comprises an underlying material and wherein the removing means comprises an overlying layer.

18. The MEMS device of Claim 16 or 17, wherein the supporting means comprises a post structure.

19. The MEMS device of Claim 18, wherein the overlying layer is configured so that a sacrificial portion of the underlying material is removable to form a cavity and wherein the overlying layer is further configured so that a remaining portion of the underlying material forms the post structure.

20. The MEMS device of Claim 16, wherein the material comprises molybdenum or silicon.

21. The MEMS device of Claim 17 or 18, wherein the overlying layer comprises an aperture configured to expose the underlying material.

22. The MEMS device of Claim 17 or 18, wherein the overlying layer comprises a plurality of apertures configured in an array.

23. The MEMS device of Claim 22, wherein the apertures comprise one of vias, trenches or channels.

24. The MEMS device of Claim 17 or 18, wherein the underlying material overlies a substrate, the substrate comprising an aperture configured to expose the underlying material.

25. The MEMS device of Claim 17 or 18, wherein the overlying layer comprises a mirror layer.

26. The MEMS device of Claim 17 or 18, wherein the overlying layer comprises an electrode.

27. The MEMS device of Claim 17 or 18, wherein the overlying layer comprises a mechanical layer.

28. The MEMS device of Claim 16, further comprising a first mirror layer and a second mirror layer, at least a portion of the material being positioned between the first mirror layer and the second mirror layer.

29. The MEMS device of Claim 28, wherein an overlying layer comprises the second mirror layer.

30. The MEMS device of Claim 28, wherein at least a portion of the second mirror layer is suspended from an overlying layer upon removal of the sacrificial portion.

31. The MEMS device of Claim 16, wherein the post structure has a re-entrant profile.

32. The method of Claim 2, wherein the interferometric modulator comprises at least a first mirror and a second mirror separated from the first mirror by a cavity, the support structure being positioned at a side of the cavity and configured to support the second mirror spaced from the first mirror, the method comprising:
providing a substrate, the substrate having a first area configured to underlie the first mirror and a second area configured to underlie the support structure;
depositing a first mirror layer over at least the first area;
depositing the material over the first area and over the second area;
depositing a second mirror layer over at least the material over the first area; and
forming a plurality of openings configured to facilitate flow of an etchant to the material over the first area;
the material over the first area being removable by the etchant to thereby form the cavity and the support structure, where the support structure comprises the material over the second area, the sacrificial portion and the remaining portion being made of a material having substantially uniform properties.

33. The method of Claim 32, wherein the material is selected from the group consisting of molybdenum and silicon.

34. The method of Claim 33, further comprising removing at least a part of the material over the first area to thereby form the cavity.

35. The method of Claim 34 wherein removing at least a part of the material over the first area to thereby form the cavity comprises a timed etch.

36. The method of Claim 34 wherein removing at least a part of the material over the first area to thereby form the cavity comprises laterally recessing the material away from the plurality of openings.

37. The method of Claim 35, wherein the etchant comprises XeF₂.

38. The method of Claim 32, wherein the plurality of openings is formed through the second mirror layer.

39. The method of Claim 32, further comprising forming a mechanical layer over at least the material over the first area.

40. The method of Claim 32, wherein the plurality of openings comprises a via.

41. The method of Claim 32, wherein the plurality of openings comprises a plurality of intersecting channels.

42. The method of Claim 1, wherein the etching comprises a timed etch.

43. The method of Claim 1, wherein the support structure comprises a post.

44. A MEMS device made or manufacturable by the method of any one of Claims 1 to 15.

45. An interferometric modulator made or manufacturable by the method of any one of Claims 32 to 41.

46. The interferometric modulator of Claim 45, wherein the support structure comprises a post structure having a re-entrant profile.

47. The interferometric modulator of Claim 46, wherein the post structure has a generally concave cross-section.

48. The interferometric modulator of Claim 46, wherein the post structure has a generally convex cross-section.

49. A system comprising the interferometric modulator of any one of Claims 45 to 48.

50. The system of Claim 49, further comprising:
a display;
a processor that is in electrical communication with the display, the processor being configured to process image data;
a memory device in electrical communication with the processor.

51. The system of Claim 50, further comprising:
a driver circuit configured to send at least one signal to the display.

52. The system of Claim 51, further comprising:
a controller configured to send at least a portion of the image data to the driver circuit.

53. The system of Claim 50, further comprising:
an image source module configured to send the image data to the processor.

54. The system of Claim 53, wherein the image source module comprises at least one of a receiver, transceiver, and transmitter.

55. The system of Claim 50, further comprising:
an input device configured to receive input data and to communicate the input data to the processor.
